# EUROPÄISCHE PATENTSCHRIFT

(11) **EP 2 133 888 B1**
(45) Veröffentlichungstag und Bekanntmachung des Hinweises auf die Patenterteilung: **10.08.2011**
(21) Anmeldenummer: 09004940.4
(22) Anmeldetag: 03.04.2009
(51) Int. Cl.: H01F 27/34, G01R 31/12, H01F 27/40

(54) **Prüfanordnung zur Wechselspannungsprüfung von elektrischen Hochspannungskomponenten**
Test assembly for AC testing of electric high voltage components
Dispositif d'essai pour des composants électriques à haute tension par courant alternatif

(30) Priorität: 12.06.2008 EP 08010691
(43) Veröffentlichungstag der Anmeldung: 16.12.2009
(73) Patentinhaber: ABB Technology AG, 8050 Zürich (CH)
(72) Erfinder: Werle, Peter, Dr.-Ing., 29664 Walsrode (DE); Steiger, Matthias, 06779 Schierau (DE); Szczechowski, Janusz, Dipl.-Ing., 04229 Leipzig (DE)
(74) Vertreter: Partner, Lothar

(56) Entgegenhaltungen:
- AT-B- 330 887
- DE-A1- 2 328 375
- DE-C- 521 475
- WINTER A ET AL: "A mobile transformer test system based on a stativ frequency converter" INTERNET CITATION, 4. September 2007 (2007-09-04), XP002500564
- HIGH VOLT: "Tunable Modular Reactors of High Power, Types DERI ... M, G" INTERNET CITATION, [Online] 1. April 2007 (2007-04-01), XP007910187 Gefunden im Internet: URL:http://www.highvolt.de/datasheets/1-22 -2.pdf> [gefunden am 2009-10-16]
- SCHUFFT W ET AL: "Frequency-tuned resonant test systems for on-site testing and diagnostics of extruded cables" HIGH VOLTAGE ENGINEERING, 1999. ELEVENTH INTERNATIONAL SYMPOSIUM ON (C ONF. PUBL. NO. 467) LONDON, UK 23-27 AUG. 1999, LONDON, UK,IEE, UK, Bd. 5, 23. August 1999 (1999-08-23), Seiten 335-339, XP006501811 ISBN: 978-0-85296-719-5
- WINTER A ET AL: "A New Generation of On-Site Test Systems for Power Transformers" 2008 IEEE INTERNATIONAL SYMPOSIUM ON ELECTRICAL INSULATION; 9-12 JUNE 2008; VANCOUVER, BC, CANADA, IEEE, 10. Juni 2008 (2008-06-10), Seiten 478-482, XP007906016 ISBN: 978-1-4244-2092-6
- SCHIERIG S ET AL: "HV AC generation based on resonant circuits with variable frequency for testing of electrical power equipment on site" CONDITION MONITORING AND DIAGNOSIS, 2008. CMD 2008. INTERNATIONAL CONFERENCE ON, IEEE, PISCATAWAY, NJ, USA, 21. April 2008 (2008-04-21), Seiten 684-691, XP031292593 ISBN: 978-1-4244-1621-9
- GRUN T ET AL: "Equipment for on-site testing of HV insulation" HIGH VOLTAGE ENGINEERING, 1999. ELEVENTH INTERNATIONAL SYMPOSIUM ON (C ONF. PUBL. NO. 467) LONDON, UK 23-27 AUG. 1999, LONDON, UK,IEE, UK, Bd. 5, 23. August 1999 (1999-08-23), Seiten 240-243, XP006501801 ISBN: 978-0-85296-719-5

## Beschreibung

Die Erfindung betrifft eine Prüfanordnung zur Wechselspannungsprüfung von elektrischen Hochspannungskomponenten mit wenigstens einem Wechselrichter, mit wenigstens einem Prüftransformator und mit wenigstens einer sich längs einer gedachten Achse erstreckenden Hochspannungsdrossel als Prüfkomponenten, wobei wenigstens die genannten Prüfkomponenten in einem gemeinsamen quaderförmigen Behälter angeordnet sind und wobei die wenigstens eine Hochspannungsdrossel mittels einer Bewegungsvorrichtung durch wenigstens eine Öffnung an einer Begrenzungsfläche des Behälters zumindest teilweise aus diesem bewegbar ist.

Es ist allgemein bekannt, dass Hochspannungskomponenten, wie beispielsweise Leistungstransformatoren, einem Alterungsprozess unterworfen sind, welcher insbesondere die elektrische Isolation betrifft. Von daher sind zur Sicherstellung eines fehlerfreien Betriebes eines elektrischen Energieverteilungsnetzes mit derartigen Hochspannungskomponenten in bestimmten Zeitintervallen Prüfungen, insbesondere der Leistungstransformatoren, erforderlich. Derartige Prüfungen geben Aufschluss über den Alterungszustand der Isolation und ermöglichen auch die Detektion anderer Fehler der betreffenden Hochspannungskomponente.

Hochspannungskomponenten wie Leistungstransformatoren weisen ein hohes Gewicht auf, je nach elektrischer Nennleistung auch über 100t. Ein Transport eines derartigen innerhalb eines elektrischen Energieverteilungsnetzes eingebauten Leistungstransformators in ein fest installiertes Prüffeld, in welchem dieser mittels einer Wechselspannungsprüfung geprüft werden könnte, ist aufgrund des hohen Transportaufwandes für den jeweiligen Leistungstransformator teilweise ausgeschlossen. Zudem ist in den seltensten Fällen genügend Redundanz in einem Energieverteilungsnetz vorhanden, dass ein Leistungstransformator ohne Beeinträchtigung des Netzbetriebes ausgebaut werden könnte.

Aus diesem Grund erfolgen derartige Wechselspannungsprüfungen von Leistungstransformatoren immer öfter vor Ort. Die Prüfanordnung mit Wechselspannungsgenerator sowie weiteren für die Prüfung benötigten Komponenten wie Hochspannungsdrossel, Spannungsteiler, Mess- und Auswertevorrichtungen wird in mehreren Baugruppen zu dem Ort, an dem sich der zu prüfende Leistungstransformator befindet, transportiert und dort zu einer Prüfanordnung montiert. Insbesondere die Hochspannungsdrossel, welche für eine Resonanzprüfung zur Bildung eines Resonanzschwingkreises mit dem Prüfling benötigt wird, ist mit einer Höhe von beispielsweise 3m und einem Innendurchmesser von beispielsweise 1m eine Prüfkomponente von beachtlicher Größe. Auch der Spannungsteiler, welcher zur Messung der hohen Spannungen von beispielsweise bis zu 500kV und höher im Resonanzschwingkreis benötigt wird, ist eine Komponente mit ähnlicher Höhe.

Bei der Durchführung einer Wechselspannungsprüfung ist darauf zu achten, dass die Komponenten der Prüfanordnung aufgrund der hohen auftretenden Spannungen einen genügend großen Abstand zueinander und zu angrenzendem Erdpotential aufweisen.

Die Montage der verschiedenen Baugruppen vor Ort ist mit einem erheblichen Zeitaufwand verbunden. So ist aus der Veröffentlichung "A mobile transformer test system based on a static frequency converter" (Winter et al., 15th International Symposium on High Voltage Engineering, University of Lljubljana, Elektroinstitut Milan Vidmar, Lljubljana, Slovenia, August 27-31, 2007) bekannt, ein statisches Prüfsystem für die Wechselspannungsprüfung von Transformatoren mit ResonanzSchwingkreis auch transportabel auszuführen, wobei diese Dokument sich überwiegend auf dessen elektrische Ausgestaltung bezieht und eine Anordnung zum möglichst zeitsparenden Aufbau des Systems vor Ort nicht genauer erläutert ist. Im Dokument "A New Generation of On-SiteTest Systems for Power Transformers"(Winter et AL; IEEE International Symposium on Electrical insulation; 9-12 Juni 2008; Vancouver, BC, Canada) ist eine mobiles Prüfsystem für lastlose Tests mit einer induzierten Spannung, insbesondere für Teilentladungsmessungen, umfassend die Komponenten statischer Frequenzkonverter, Niederspannungskompensationseinheit, Hochsetztransformator, Kontrollraum, Hochspannungsfilter und Messtransformator offenbart. Dieses System ist komplett in einem Container untergebracht und auch in diesern betreibbar, weist jedoch keine platzintensive Hochspannungsdrossel auf.

Bei einigen Wechselspannungsprüfungen ist ein zusätzlicher Schutz der Hochspannungsdrossel vor Spannungssprüngen und Überspannungen erforderlich. Dieser erfordert bisher eine separat zu transportierende und vor Ort aufzubauende Schutzvorrichtung. Eine geeignete Schutzvorrichtung ist beispielsweise mittels eines kapazitiven Teilers realisierbar.

Das Dokument DE 2328375 betrifft eine Kondensatorbatterie zur Spannungssteuerung an Drosseln wobei jedem zu steuernden Wicklungsabschnitt ein Einzelkondensator parallelgeschaltet ist, Das Dokument AT 330887 offenbart eine eisenkernlose Hochscannungsdrossel in Trockenbauweise für Freiluftaufstellung mit einer annährend gleichmäßigen Verteilung auftretender Stoßspannungen auf die Drosselspulenwicktung. Das Dokument "Tunable Modular Reactors of High Power DERI ... M, G" (HighVolt, 1.April 2007; gefunden am 16.10.2009 im Internet unter http://www.highvolt.de/datasheets/1-22-2.pdf)offenbart eine modulare Spule für Resonanzsysteme.

Ausgehend hiervon ist es Aufgabe der Erfindung, eine kompakte Prüfanordnung mit einem Überspannungsschutz für die Hochspannungsdrossel anzugeben.

Diese Aufgabe wird gelöst durch eine Prüfanordnung nach Anspruch 1.

Diese Prüfanordnung weist wenigstens eine Hochspannungsdrossel mit einem integrierten Überspannungsschutz auf.

Eine Hochspannungsdrossel ist beispielsweise hohlzylindrisch ausgeprägt wobei deren Raumbedarf in einer erfindungsgemäßen Prüfanordnung sich nach deren Höhe und der quadratischen Grundfläche der eigentlich runden Standfläche bestimmt. Es ist somit längs der axialen Erstreckung der Hochspannungsdrossel sowohl in deren innerem Hohlraum als auch in den äußeren Ecken, welche sich aus der Differenz der quadratischen Grundfläche zur runden Standfläche ergeben, ein ungenutzter Raum vorhanden.

Ein Überspannungsschutz schließt die beiden Anschlüssen der Hochspannungsdrossel bei auftretenden höheren Spannungen kurz. Derartige Überspannungen treten beispielsweise bei einem Stromabriss an der Hochspannungsdrossel in Form von hochfrequenten Ausgleichsvorgängen auf, was dem Fachmann jedoch bekannt ist.

Bei der Integration eines Überspannungsableiters in den zuvor genannten unbenutzten Raum um die bzw. in der Hochspannungsdrossel ist insbesondere vorteilhaft, dass es sich um eine Schutzvorrichtung mit reduzierten Genauigkeitsanforderungen und nicht um eine Messvorrichtung wie beispielsweise einen Spannungswandler handelt. Somit lässt sich ein Überspannungsableiter ohne zusätzlichen Raumbedarf in den bereits vorhandenen ungenutzten Raum in der bzw. um die Hochspannungsdrossel integrieren.

In einer bevorzugten Ausgestaltung der erfindungsgemäßen Prüfanordnung ist für die Hochspannungsdrossel ein mechanisch mit dieser verbundener Kondensator, welcher elektrisch zumindest abschnittsweise parallel zum Strompfad durch die Hochspannungsdrossel geschaltet ist, als integrierter Überspannungsschutz vorgesehen.

In einer weiteren Variante der erfindungsgemäßen Prüfanordnung weist die Hochspannungsdrossel wenigstens zwei elektrisch in Reihe geschaltete Spulensegmente mit jeweils zwei Wicklungsenden auf.

Ein Spulensegment umfasst wenigstens einen Wicklungsabschnitt, bevorzugter Weise aber auch einen Wickelkörper, auf welchem die Wicklung angeordnet ist. Durch den modularen Aufbau einer Hochspannungsdrossel aus Spulensegmenten ist deren Konstruktion in vorteilhafter Weise vereinfacht.

Entsprechend einer bevorzugten Ausgestaltung der erfindungsgemäßen Prüfanordnung sind die wenigstens zwei Spulensegmente hohlzylindrisch ausgeformt und längs der gedachten Achse benachbart angeordnet wobei diese die jeweiligen hohlzylindrischen Innenräume durchgreift.

Die hohlzylindrische Ausformung eines Spulensegmentes ist besonders vorteilhaft zu fertigen und die Anordnung mehrerer vorzugsweise baugleicher Spulensegmente längs einer Line ermöglicht einen verfügbaren Raum für einen integrierten Überspannungsableiter, welcher sich längs einer Linie erstreckt. Hierdurch wird die Integration des Überspannungsleiters vereinfacht.

Gemäß einer weiteren Ausführungsform der Prüfanordnung sind die wenigstens zwei Spulensegmente der Hochspannungsdrossel längs der gedachten Achse auf einem gemeinsamen zylindrischen Hohlkörper angeordnet, welcher vorzugsweise überwiegend aus einem Isolationsmaterial besteht. Hierdurch wird der mechanische Aufbau der Hochspannungsdrossel besonders vereinfacht.

In einer weiteren Variante der erfindungsgemäßen Prüfanordnung ist jedem Spulensegment wenigstens ein mechanisch mit der Hochspannungsdrossel verbundener Kondensator zugeordnet und elektrisch mit den jeweiligen beiden Wicklungsenden elektrisch parallel geschaltet. Auf diese Weise ist jedes Spulensegment von einem zugeordneten Kondensator gegen hochfrequente Überspannungen geschützt. Die Modularität der Spulensegmente wird hierdurch auch auf die Kondensatoren für den Überspannungsschutz übertragen.

Entsprechend einer weiteren Ausgestaltung der erfindungsgemäßen Prüfanordnung sind eine elektrische Reihenschaltung von wenigstens zwei Spulensegmenten und eine elektrische Reihenschaltung von wenigstens zwei mechanisch mit der Hochspannungsdrossel verbundenen Kondensatoren elektrisch parallel miteinander geschaltet.

Dies ist insbesondere für Ausgestaltungen des Überspannungsableiters vorteilhaft, bei denen ein Parallelschalten eines Kondensators mit einem Spulenelement aufgrund der gewählten Anordnung nicht oder nur schwer möglich ist. Dies kann sowohl eine in Reihe geschaltete Kondensatorenkette im inneren Hohlraum der Hochspannungsdrossel umfassen, aber auch eine Kondensatorenkette, die mit den Wickelkörpern der Wicklungssegmente verbunden ist bzw. aus diesen gebildet wird.

Demgemäß ist in einer weiteren erfindungsgemäßen Prüfanordnung wenigstens ein mechanisch mit der Hochspannungsdrossel verbundener Kondensator zwischen zwei längs der gedachten Achse benachbarten Spulensegmenten angeordnet. Ein derartiger Kondensator hat beispielsweise die Form eines sehr flachen Hohlzylinders mit etwa demselben Innendurchmesser wie ein Spulensegment. Somit lassen sich Spulensegmente und Kondensatoren vorzugsweise in abwechselnder Reihenfolge um denselben zylindrischen Hohlkörper anordnen. Die elektrische Reihenschaltung der Spulensegmente ist hierbei unbeeinflusst, während die elektrische Reihenschaltung der Kondensatoren beispielsweise auch über die Wickelkörper der angrenzenden Spulensegmente erfolgen kann, welche dann über eine zumindest abschnittsweise Leitfähigkeit längs ihrer axialen Erstreckung verfügen. Eine elektrische Parallelschaltung der so gebildeten Kondensatorkette und der Spulensegmentkette erfolgt dann an deren beiden Enden.

In einer besonders bevorzugten Ausgestaltung der Prüfanordnung ist wenigstens ein den beiden Wicklungsenden eines Spulensegments elektrisch parallel geschalteter Kondensator mechanisch mit diesem verbunden.

In einer weiteren Variante der erfindungsgemäßen Prüfanordnung ist wenigstens jeweils ein Kondensator im inneren Hohlraum jedes Spulensegmentes der Hochspannungsdrossel angeordnet und elektrisch mit diesem verbunden. Dies ermöglicht einen modularen Aufbau einer Hochspannungsdrossel aus Spulensegmenten, wobei beispielsweise zwei Bohrungen durch den zylindrischen Hohlkörper zur Durchführung der elektrischen Verbindungen des Kondensators vorgesehen sind. Weiterhin ist der Kondensator vorteilhaft mit der inneren Hohlraumwandung mechanisch verbunden um so eine mechanisch Stabilität zu gewährleisten.

In einer Variante der erfindungsgemäßen Prüfanordnung ist an dem erdfernen axialen Ende der Hochspannungsdrossel eine torusähnliche Elektrode zur Steuerung des elektrischen Potentials vorgesehen. Derartige Steuerelektroden sind insbesondere bei Prüfanordnungen geeignet, um eine definierte Potentialverteilung zu gewährleisten.

In einer besonders bevorzugten Ausgestaltung der erfindungsgemäßen Prüfanordnung ist ein säulenänlicher Spannungsteiler parallel zur Erstreckung der Hochspannungsdrossel auf gleicher Höhe angeordnet, wobei sowohl der Spannungsteiler als auch die Hochspannungsdrossel elektrisch mit der torusähnlichen Elektrode verbunden sind. Durch das Unterbringen unter einer gemeinsame Steuerelektrode lässt sich der Abstand zwischen Hochspannungsdrossel und Spannungsteiler in vorteilhafter Weise reduzieren.

Bevorzugt sind der säulenähnliche Spannungsteiler und die Hochspannungsdrossel auch mechanisch miteinander verbunden und werden auch durch eine gemeinsame Bewegungsvorrichtung aus dem quaderförmigen Behälter heraus- und hineinbewegt. Der Platzbedarf für die erfindungsgemäße Prüfanordnung wird dadurch weiter reduziert.

Weitere vorteilhafte Ausgestaltungsmöglichkeiten sind den weiteren abhängigen Ansprüchen zu entnehmen.

Anhand der in den Zeichnungen dargestellten Ausführungsbeispiele sollen die Erfindung, weitere Ausführungsformen und weitere Vorteile näher beschrieben werden.

Es zeigen:
- Fig. 1: eine Seitenansicht auf eine Prüfanordnung,
- Fig. 2: eine exemplarische Prüfschaltung,
- Fig. 3: eine exemplarische erste Hochspannungsdrossel,
- Fig. 4: eine exemplarische zweite Hochspannungsdrossel,
- Fig. 5: eine exemplarische dritte Hochspannungsdrossel,
- Fig. 6: eine vierte Hochspannungsdrossel mit separatem erstem Spannungsteiler und
- Fig. 7: eine fünfte Hochspannungsdrossel mit integriertem zweiten Spannungstei- ler

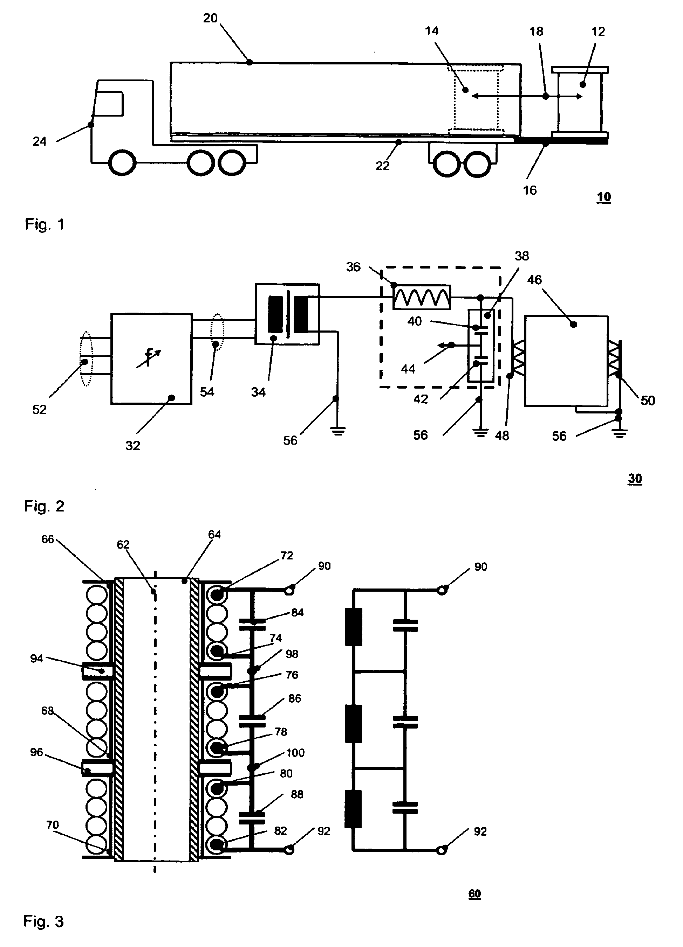

Fig. 1 zeigt eine Seitenansicht auf eine exemplarische Prüfanordnung 10. In einem Container 20 sind die Komponenten eine Prüfschaltung zur Wechselspannungsprüfung von Hochspannungskomponenten wie Leistungstransformatoren angeordnet. Sichtbare Prüfkomponente ist in dieser Fig. lediglich die Hochspannungsdrossel 12, welche über eine Bewegungsvorrichtung 16 durch die hintere Stirnwand des Containers 20 in der Bewegungsrichtung 18 herausgefahren ist. Die Position der Hochspannungsdrossel im eingefahrenen Zustand innerhalb des Containers ist gestrichelt mit der Bezugsnummer 14 angedeutet. Im eingefahrenen Zustand wird die Prüfanordnung 10 für den Transportzustand derart kompakt, dass sie komplett in den Container 20 unterzubringen ist, während durch das Herausfahren der Hochspannungsdrossel 12 insbesondere die für die elektrische Wechselspannungsprüfung notwendigen elektrischen Isolationsabstände zu weiteren Komponenten der Prüfanordnung 10 sichergestellt sind.

Der Container 20 ist vorzugsweise nach den Richtlinien der CSC (=Container Safety Convention) zugelassen, so dass er beispielsweise auch auf einem Containerschiff in jeder beliebigen Position innerhalb eines Containerstapels platzierbar ist und dessen weltweiter Transport damit weiter vereinfacht ist. In der Fig. ist er jedoch auf einem Auflieger 22 eines LKW 24 gezeigt.

Fig. 2 zeigt eine exemplarische Prüfschaltung 30 für eine Wechselspannungsprüfung von Hochspannungskomponenten, ähnlich der in dem Container der zuvor gezeigten Fig. angeordneten Prüfschaltung. Eine dreiphasige Versorgungsspannung 52, beispielsweise 380V Drehstrom, wird einem Wechselrichter 52 zugeführt, welcher an seinem Ausgang 54 eine frequenzgerichtete Wechselspannung produziert, deren Frequenz in dem Resonanzbereich des nachfolgenden elektrischen Resonanzkreise liegt, beispielsweise einige 100Hz. Über einen Zwischentransformator 34 wird diese Spannung auf ein höheres Spannungsniveau transformiert, welche den im Wesentlichen aus der Hochspannungsdrossel 36 und dem Prüfling 46 gebildeten Resonanzschwingkreis anregt, wobei verfahrensgemäß Spannungen bis zu mehreren 100kV auftreten. Zwischen der Hochspannungsdrossel 36 und dem Prüfling 46 wird die gegen Erde 56 anliegende Spannung über einen Spannungsteiler 38, welcher im Wesentlichen einen ersten 40 und einen zweiten 42 Spannungsteilerkondensator aufweist, abgegriffen und in eine Messspannung 44 umgewandelt, welche dann einer nicht gezeigten Auswerteelektronik zugeführt wird. In diesem Beispiel sind sowohl die Primäreingänge 48 als auch die Sekundäreingänge 50 des Prüflings jeweils miteinander verbunden, wobei der Sekundäreingänge 50 auf Erdpotential 56 geschaltet sind. Alle genannten Komponenten mit Ausnahme des Prüflings 46 sind in einem gemeinsamen Behälter angeordnet.

Überspannungen, gegen welche die Hochspannungsdrossel 36 erfindungsgemäß zu schützen ist, treten beispielsweise bei einem während der Prüfung erfolgenden Durchschlag im Prüfling 46 auf, so dass sich dessen Innenimpedanz schlagartig ändert. In diesem Fall würde die Hochspannungsdrossel 36 den sie durchfließenden momentanen Strom, der an einer Induktivität nicht springen kann, weitertreiben, was dann zu entsprechenden hochfrequenten Ausgleichsvorgängen mit entsprechenden Überspannungen zwischen den Anschlüssen der Hochspannungsdrossel 36 führt.

Fig. 3 zeigt eine exemplarische erste Hochspannungsdrossel 60. Längs einer gedachten Achse 62 ist ein zylindrischer Hohlkörper 64 angeordnet, welcher die mechanische Basis für die Hochspannungsdrossel 60 bildet. Um den zylindrischen Hohlkörper herum und ebenfalls längs der gedachten Achse 62 sind ein erstes 66, ein zweites 68 und ein drittes 68 hohlzylindrisches Spulensegment axial benachbart angeordnet, wobei jedes Spulensegment jeweils einen Wickelkörper und eine Teilwicklung mit jeweils einem ersten 72, 76, 80 und zweitem 74, 78, 82 Wicklungsende aufweist. Die Teilwicklungen der drei Spulensegmente 62, 66, 70 sind an der ersten 98 bzw. zweiten 100 elektrischen Verbindung elektrisch in Reihe geschaltet, so dass sich daraus die Gesamtwicklung bzw. -induktivität der Hochspannungsdrossel 60 ergibt. Eine reale Hochspannungsdrossel kann aber durchaus auch deutlich mehr Wicklungssegmente, beispielsweise zehn oder zwanzig, aufweisen.

Zwischen den axial benachbarten Spulensegmenten 62, 66, 70 sind ebenfalls hohlzylindrisch ausgeprägte, aber deutlich flachere Zwischenstücke 94 bzw. 96 angeordnet, welche eine mechanische axiale Beabstandung zwischen den Spulensegmenten 62, 66, 70 gewährleisten, was aber nicht zwingend erforderlich ist. Radial außen an der Hochspannungsdrossel sind Kondensatoren 84, 86, 88 angeordnet, welche in der Fig. jedoch durch ihr Ersatzschaltbild angedeutet sind. Jedem Wicklungsteil eines jeweiligen Spulensegmentes 62, 66, 70 ist ein zugehöriger Kondensator 84, 86, 88 parallel geschaltet, so dass sich ein segmentweiser Überspannungsschutz ergibt, wie sich auch aus dem rechts in der Fig. gezeigten entsprechenden elektrischen Ersatzschaltbild ergibt, an welchem auch die beiden elektrischen Anschlüsse 90, 92 der Hochspannungsdrossel gezeigt sind.

Die Anordnung der Kondensatoren 84, 86, 88 ist derart, dass sie in einem oder auch mehreren Eckbereichen der quadratischen Grundfläche der Hochspannungsdrossel 62 positioniert sind, wobei ein Eckbereich sich aus der Differenz zu der an sich runder Standfläche ergeben. Vorzugsweise ist eine mechanische Halterung bzw. Verbindung zu der Hochspannungsdrossel vorzusehen, so dass sich eine entsprechend hohe mechanische Stabilität ergibt.

Bei gleichartigen Kondensatoren 84, 86, 88 ist im Falle einer hochfrequenten Überspannung der Spannungsabfall längs jedes Kondensators gleich. Somit ist jedes Wicklungssegment durch den ihm zugeordneten Kondensator vor einer jeweiligen Überspannung geschützt.

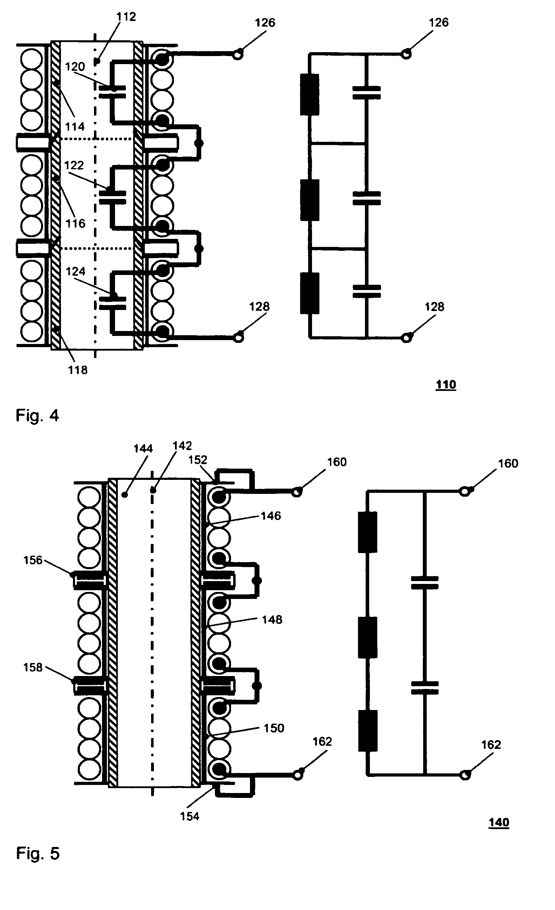

Fig. 4 zeigt eine exemplarische zweite Hochspannungsdrossel 110 mit entsprechendem Ersatzschaltbild, welches dem in der Fig. 3 gezeigten Ersatzschaltbild entspricht. Der wesentliche Unterschied zu Fig. 3 besteht darin dass die drei Spulensegmente längs der gedachten Achse 112 nicht um einen gemeinsamen zylindrischen Hohlkörper sondern vielmehr um drei aneinander gereihte und mittels einer formschlüssigen Verbindung miteinander verbundene einzelne zylindrische Hohlkörper 114, 116, 118 angeordnet sind. Diese Aufteilung ist deshalb zweckmäßig, weil in diesem Beispiel die drei jeweils den Spulensegmenten zugeordneten Kondensatoren 120, 122, 124 im inneren Hohlraum der zylindrischen Hohlkörper 114, 116, 118 angeordnet sind, wobei diese mit ihrem elektrischen Ersatzschaltbild angedeutet sind. Um eine elektrische Parallelschaltung zu den zugehörigen Wicklungsteilen zu ermöglichen sind jeweils zwei Durchbrüche durch die Wandungen der Hohlkörper zur Führung der elektrischen Verbindung vorgesehen. Die Montage der Einzelsegmente wird durch die Segmentierung auch des zylindrischen Hohlkörpers vereinfacht.

Die beiden Anschlussklemmen der Hochspannungsdrossel sind auch im entsprechenden rechts dargestellten elektrischen Ersatzschaltbild mit den Bezugszeichen 126 und 128 gekennzeichnet.

Fig. 5 zeigt eine exemplarische dritte Hochspannungsdrossel 140. Der wesentliche Unterschied zu der in der Fig. 3 gezeigten Hochspannungsdrossel besteht darin, dass die um die gedachte Achse 142 auf dem zylindrischen Hohlkörper 144 angeordneten Spulensegmente 146, 148, 150 nunmehr axial durch jeweils einen hohlzylindrischen, flachen und scheibenähnlichen Zwischenkondensator 156, 158 getrennt sind. Sowohl die Spulensegmente 146, 148, 150 als auch die Zwischenkondensatoren 156, 158 sind jeweils elektrisch in Reihe geschaltet, wobei die beiden Reihenschaltungen an ihren jeweiligen Endpunkten an den Anschlüssen 160 bzw. 162 der Hochspannungsdrossel 140 miteinander parallel geschaltet sind, so dass sich das rechts in der Fig. gezeigte elektrische Ersatzschaltbild ergibt. In diesem Fall sind die Spulenkörper der jeweiligen Spulensegmente zumindest längs ihrer axialen Länge elektrisch leitend auszuführen - beispielsweise durch Ausführung aus einem Metall bzw. durch Integration eines Kabelleiters - so dass eine elektrische Reihenschaltung der Kondensatoren 156, 158 ermöglicht ist. Es auch denkbar, dass die Kondensatoren durch die Spulenkörper selbst gebildet werden, wobei dann an der axialen Grenzfläche zwischen zwei Kondensatoren wenigstens eine Schicht mit einem Dielektrikum vorzusehen ist.

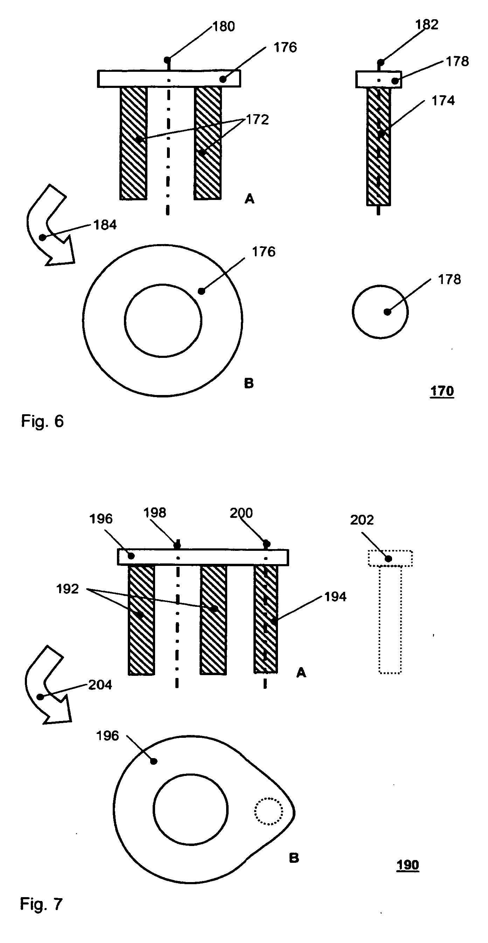

Fig. 6 zeigt eine vierte Hochspannungsdrossel 172 mit separatem ersten Spannungsteiler 174 in einer Darstellung 170, wobei eine Schnittansicht von der Seite mit dem Buchstaben A und eine Draufsicht mit dem Buchstaben B gekennzeichnet ist. Die Hochspannungsdrossel 172 ist ebenso wie die an ihrem erdfernen Ende angebrachte torusähnliche Steuerelektrode 176 rotationssymmetrisch um eine gedachte Achse 180 angeordnet. Der längs einer gedachten Achse 182 verlaufende und in einem Abstand zur Hochspannungsdrossel befindliche säulenähnliche Spannungsteiler 174 ist an seinem erdfernen Ende ebenfalls mit einer torusähnlichen Steuerelektrode zur Gewährleistung einer definierten Verteilung des elektrischen Potentials versehen. Dies entspricht einer Anordnung entsprechend dem Stand der Technik.

Fig. 7 zeigt eine fünfte Hochspannungsdrossel 192 mit integriertem zweiten Spannungsteiler 194 in einer Darstellung 190, wobei eine Schnittansicht von der Seite mit dem Buchstaben A und eine Draufsicht mit dem Buchstaben B gekennzeichnet ist. Die Hochspannungsdrossel 192 erstreckt sich längs der gedachten Achse 198, wobei in einem geringen Abstand, beispielsweise 20cm, von der Außenkante der Hochspannungsdrossel entfernt längs der gedachten Achse 200 der säulenähnliche Spannungsteiler 194 angeordnet ist. Die gemeinsame Steuerelektrode 196 ist in diesem Beispiel nur näherungsweise torusförmig ausgeprägt.

### Bezugszeichenliste

- 10: Seitenansicht auf eine Prüfanordnung
- 12: erste Hochspannungsdrossel
- 14: Position der ersten Hochspannungsdrossel in eingefahrenenm Zustand
- 16: Bewegungsvorrichtung
- 18: Bewegungsrichtung
- 20: Container
- 22: Auflieger
- 24: LKW
- 30: Exemplarische Prüfschaltung
- 32: Wechselrichter
- 34: Zwischentransformator
- 36: zweite Hochspannungsdrossel
- 38: Spannungsteiler
- 40: erster Spannungsteilerkondensator
- 42: zweiter Spannungsteilerkondensator
- 44: Abgriff für Messspannung
- 46: Prüfling
- 48: Parallel geschaltete Primärseite des Prüflings
- 50: Parallel geschaltete Sekundärseite des Prüflings
- 52: Dreiphasige Versorgungsspannung
- 54: Ausgang des Wechselrichters
- 56: Erdung
- 60: exemplarische erste Hochspannungsdrossel
- 62: erste gedachte Achse
- 64: erster zylindrischer Hohlkörper
- 66: erstes Spulensegment der ersten Hochspannungsdrossel
- 68: zweites Spulensegment der ersten Hochspannungsdrossel
- 70: drittes Spulensegment der ersten Hochspannungsdrossel
- 72: erstes Wicklungsende des ersten Spulensegmentes
- 74: zweites Wicklungsende des ersten Spulensegmentes
- 76: erstes Wicklungsende des zweiten Spulensegmentes
- 78: zweites Wicklungsende des zweiten Spulensegmentes
- 80: erstes Wicklungsende des dritten Spulensegmentes
- 82: zweites Wicklungsende des dritten Spulensegmentes
- 84: erster Kondensator
- 86: zweiter Kondensator
- 88: dritter Kondensator
- 90: erster Anschluss der ersten Hochspannungsdrossel
- 92: zweiter Anschluss der ersten Hochspannungsdrossel
- 94: erstes Zwischenstück der ersten Hochspannungsdrossel
- 96: zweites Zwischenstück der ersten Hochspannungsdrossel
- 98: erste elektrische Verbindung
- 100: zweite elektrische Verbindung
- 110: exemplarische zweite Hochspannungsdrossel
- 112: zweite gedachte Achse
- 114: zweiter zylindrischer Hohlkörper
- 116: dritter zylindrischer Hohlkörper
- 118: vierter zylindrischer Hohlkörper
- 120: erster Hohlraumkondensator
- 122: zweiter Hohlraumkondensator
- 124: dritter Hohlraumkondensator
- 126: erster Anschluss der zweiten Hochspannungsdrossel
- 128: zweiter Anschluss der zweiten Hochspannungsdrossel
- 140: exemplarische dritte Hochspannungsdrossel
- 142: dritte gedachte Achse
- 144: fünfter zylindrischer Hohlkörper
- 146: erstes Spulensegment der dritten Hochspannungsdrossel
- 148: zweites Spulensegment der dritten Hochspannungsdrossel
- 150: drittes Spulensegment der dritten Hochspannungsdrossel
- 152: Leiteranschluss an erstes Spulensegment
- 154: Leiteranschluss an drittes Spulensegment
- 156: erster Zwischenkondensator
- 158: zweiter Zwischenraumkondensator
- 160: erster Anschluss der dritten Hochspannungsdrossel
- 162: zweiter Anschluss der dritten Hochspannungsdrossel
- 170: vierte Hochspannungsdrossel mit separatem erstem Spannungsteiler
- 172: vierte Hochspannungsdrossel
- 174: erster Spannungsteiler
- 176: torusähnliche Steuerelektrode der vierten Hochspannungsdrossel
- 178: torusähnliche Steuerelektrode des ersten Spannungsteilers
- 180: vierte gedachte Achse
- 182: fünfte gedachte Achse
- 184: Drehung der Perspektive
- 190: fünfte Hochspannungsdrossel mit integriertem zweiten Spannungsteiler
- 192: fünfte Hochspannungsdrossel
- 194: zweiter Spannungsteiler
- 196: gemeinsame torusähnliche Steuerelektrode
- 198: sechste gedachte Achse
- 200: siebte gedachte Achse
- 202: angedeutete Position des zweiten Spannungsteilers
- 204: Drehung der Perspektive

## Patentansprüche

1. Prüfanordnung (10) zur Wechseispannungsprüfung von elektrischen Hochspannungskomponenten (46), umfassend
- wenigstens einen Wechselrichter (32),
- wenigstens einen Prüftransformator (34),
- wenigstens einen sich längs einer gedachten Achse (62, 112, 142, 180, 198) erstreckende Hochspannungsdrossel (12, 60, 110, 140, 172, 192)
als Prüfkomponenten, wobei wenigstens die genannten Prüfkomponenten in einem quaderförmigen Behälter (20) angeordnet sind, wobei die wenigstens eine Hochspannungsdrossel (12, 60, 110, 140, 172, 192) mittels einer Bewegungsvorrichtung (16) durch wenigstens eine Öffnung an einer Begrenzungsfläche des Behälters (20) zumindest teilweise aus diesem bewegbar ist, wobei die wenigstens eine Hochspannungsdrossel (12, 60, 110, 140, 172, 192) als integrierten Überspannungsschutz wenigstens einen mechanisch mit dieser verbundenen Kondensator (84, 86, 88, 120, 122, 124, 156, 158) aufweist, welcher elektrisch parallel zum Strompfad durch die Hochspannungsdrossel geschaltet ist, **dadurch gekennzeichnet,**
**dass** der quaderförmige Behälter (20) und die Bewegungsvorrichtung (16) Bestandteil der Prüfanordnung sind und dass die Hochspannungsdrossel (12, 60, 110, 140, 172, 192) mit der Bewegungsvorrichtung (16) in eine Position außerhalb des Behälters (20) verbringbar ist, in welcher die für eine elektrische Wechselspannungsprüfung notwendigen elektrischen Isolationsabstände zu weiteren Komponenten der Prüfanordnung sichergestellt sind.

2. Prüfanordnung nach Anspruch 1, **dadurch gekennzeichnet, dass** die Hochspannungsdrossel (12, 60, 110, 140, 172, 192) wenigstens zwei elektrisch in Reihe geschaltete Spulensegmente (66, 68, 70, 146, 148, 150) mit jeweils zwei Wicklungsenden (72, 74, 76, 78, 80, 82) aufweist.

3. Prüfanordnung nach Anspruch 2, **dadurch gekennzeichnet, dass** die wenigstens zwei Spulensegmente (66, 68, 70, 146, 148, 150) hohlzylindrisch ausgeformt und längs der gedachten Achse (62, 112, 142, 180, 198) benachbart angeordnet sind wobei diese die jeweiligen hohlzylindrischen Innenräume durchgreift.

4. Prüfanordnung nach Anspruch 3, **dadurch gekennzeichnet, dass** die wenigstens zwei Spulensegmente (66, 68, 70, 146, 148, 150) längs der gedachten Achse (62, 112, 142, 180, 198) auf einem gemeinsamen zylindrischen Hohlkörper (64, 144) angeordnet sind.

5. Prüfanordnung nach einem der Ansprüche 2 bis 4, **dadurch gekennzeichnet, dass** jedem Spulensegment (66, 68, 70, 146, 148, 150) wenigstens ein mechanisch mit der Hochspannungsdrossel (12, 60, 110, 140, 172, 192) verbundener Kondensator (84, 86, 88, 120, 122, 124, 156, 158) zugeordnet und elektrisch mit den jeweiligen beiden Wicklungsenden (72, 74, 76, 78, 80, 82) elektrisch parallel geschaltet ist.

6. Prüfanordnung nach einem der Ansprüche 2 bis 4, **dadurch gekennzeichnet, dass** eine elektrische Reihenschaltung von wenigstens zwei Spulensegmenten (146, 148, 150) und eine elektrische Reihenschaltung von wenigstens zwei mechanisch mit der Hochspannungsdrossel verbundenen Kondensatoren (156, 158) elektrisch parallel miteinander geschaltet sind.

7. Prüfanordnung nach Anspruch 6, **dadurch gekennzeichnet, dass** wenigstens ein mechanisch mit der Hochspannungsdrossel verbundener Kondensator (156, 158) zwischen zwei längs der gedachten Achse (142) benachbarten Spulensegmenten (146, 148, 150) angeordnet ist.

8. Prüfanordnung nach einem der Ansprüche 5 bis 7, **dadurch gekennzeichnet, dass** wenigstens ein den beiden Wicklungsenden (72, 74, 76, 78, 80, 82) eines Spulensegments elektrisch parallel geschaltete Kondensator (84, 86, 88, 120, 122, 124, 156, 158) mechanisch mit diesem verbunden ist.

9. Prüfanordnung nach einem der Ansprüche 3 bis 8, **dadurch gekennzeichnet, dass** wenigstens ein Kondensator (129, 122, 124) im inneren Hohlraum der Spulensegmente der Hochspannungsdrossel (110) angeordnet und elektrisch mit dieser verbunden ist.

10. Prüfanordnung nach einem der vorangegangenen Ansprüche, **dadurch gekennzeichnet, dass** an dem erdfernen axialen Ende der Hochspannungsdrossel (172, 192) eine torusähnliche Elektrode (176, 196) zur Steuerung des elektrischen Potentials vorgesehen ist.

11. Prüfanordnung nach Anspruch 10, **dadurch gekennzeichnet, dass** ein säulenänlicher Spannungsteiler (194) parallel zur Erstreckung der Hochspannungsdrossel (192) auf gleicher Höhe angeordnet ist, wobei sowohl der Spannungsteiler (194) als auch die Hochspannungsdrossel (192) elektrisch mit der torusähnlichen Elektrode (196) verbunden sind.

12. Prüfanordnung nach Anspruch 11, **dadurch gekennzeichnet, dass** der säulenähnliche Spannungsteiler (194) in einem Abstand neben der Hochspannungsdrossel (192) angeordnet und mit dieser mechanisch verbunden ist.

## Claims

1. Test arrangement (10) for AC voltage testing of high-voltage electrical components (46), comprising
- at least one inverter (32),
- at least one test transformer (34),
- at least one high-voltage inductor (12, 60, 110, 140, 172, 192), which extends along an imaginary axis (62, 112, 142, 180, 198),
as test components, wherein at least the mentioned test components are arranged in a cuboid container (20), wherein the at least one high-voltage inductor (12, 60, 110, 140, 172, 192) can be moved at least partially out of the container (20) by means of a movement apparatus (16), through at least one opening in a limit face of the container (20), wherein the at least one high-voltage inductor (12, 60, 110, 140, 172, 192) has, as integrated surge protection, at least one capacitor (84, 86, 88, 120, 122, 124, 156, 158), which is connected mechanically to said high-voltage inductor and is connected electrically in parallel with the current path through the high-voltage inductor, **characterized**
**in that** the cuboid container (20) and the movement apparatus (16) are part of the test arrangement, and in that the high-voltage inductor (12, 60, 110, 140, 172, 192) can be brought into a position outside the container (20) by the movement apparatus (16), in which position the electrical insulation gaps, necessary for electrical AC voltage testing, with respect to further components of the test arrangement are ensured.

2. Test arrangement according to Claim 1, **characterized in that** the high-voltage inductor (12, 60, 110, 140, 172, 192) has at least two coil segments (66, 68, 70, 146, 148, 150) which are connected electrically in series and each have two end windings (72, 74, 76, 78, 80, 82).

3. Test arrangement according to Claim 2, **characterized in that** the at least two coil segments (66, 68, 70, 146, 148, 150) are hollow-cylindrical in shape and are arranged adjacent to one another along the imaginary axis (62, 112, 142, 180, 198), wherein said imaginary axis passes through the respective hollow-cylindrical interiors.

4. Test arrangement according to Claim 3, **characterized in that** the at least two coil segments (66, 68, 70, 146, 148, 150) are arranged along the imaginary axis (62, 112, 142, 180, 198) on a common cylindrical hollow body (64, 144).

5. Test arrangement according to one of Claims 2 to 4, **characterized in that** at least one capacitor (84, 86, 88, 120, 122, 124, 156, 158), which is connected mechanically to the high-voltage inductor (12, 60, 110, 140, 172, 192), is assigned to each coil segment (66, 68, 70, 146, 148, 150) and is connected electrically in parallel electrically to the respective two end windings (72, 74, 76, 78, 80, 82).

6. Test arrangement according to one of Claims 2 to 4, **characterized in that** an electrical series circuit comprising at least two coil segments (146, 148, 150) and an electrical series circuit comprising at least two capacitors (156, 158), which are connected mechanically to the high-voltage inductor, are connected electrically in parallel with one another.

7. Test arrangement according to Claim 6, **characterized in that** at least one capacitor (156, 158), which is connected mechanically to the high-voltage inductor, is arranged between two coil segments (146, 148, 150) which are adjacent to one another along the imaginary axis (142).

8. Test arrangement according to one of Claims 5 to 7, **characterized in that** at least one capacitor (84, 86, 88, 120, 122, 124, 156, 158), which is connected electrically in parallel with the two end windings (72, 74, 76, 78, 80, 82) of a coil segment, is connected mechanically to said coil segment.

9. Test arrangement according to one of Claims 3 to 8, **characterized in that** at least one capacitor (120, 122, 124) is arranged in the inner cavity of the coil segments of the high-voltage inductor (110) and is connected electrically thereto.

10. Test arrangement according to one of the preceding claims, **characterized in that**, at that axial end of the high-voltage inductor (172, 192) which is remote from the ground, a toroidal electrode (176, 196) is provided for controlling the electrical potential.

11. Test arrangement according to Claim 10, **characterized in that** a pillar-like voltage divider (194) is arranged in parallel to the extent of the high-voltage inductor (192) at the same height, wherein both the voltage divider (194) and the high-voltage inductor (192) are connected electrically to the toroidal electrode (196).

12. Test arrangement according to Claim 11, **characterized in that** the pillar-like voltage divider (194) is arranged at a distance next to the high-voltage inductor (192) and is connected mechanically thereto.

## Revendications

1. Arrangement de contrôle (10) pour contrôler la tension alternative de composants à haute tension électriques (46) comprenant
- au moins un onduleur (32),
- au moins un transformateur de contrôle (34),
- au moins une bobine à haute tension (12, 60, 110, 140, 172, 192) qui s'étend le long d'un axe imaginaire (62, 112, 142, 180, 198)
en tant que composants de contrôle, au moins lesdits composants de contrôle étant disposés dans un récipient (20) parallélépipédique, l'au moins une bobine à haute tension (12, 60, 110, 140, 172, 192) pouvant être déplacée au moyen d'un dispositif de déplacement (16) au moins partiellement hors du récipient (20) à travers au moins une ouverture sur une surface de délimitation de celui-ci, l'au moins une bobine à haute tension (12, 60, 110, 140, 172, 192) présentant comme protection intégrée contre les surtensions au moins un condensateur (84, 86, 88, 120, 122, 124, 156, 158) relié mécaniquement à celle-ci, lequel est branché électriquement en parallèle avec le trajet du courant à travers la bobine à haute tension, **caractérisé en ce que** le récipient (20) parallélépipédique et le dispositif de déplacement (16) font partie intégrante de l'arrangement de contrôle et **en ce que** la bobine à haute tension (12, 60, 110, 140, 172, 192) peut être amenée avec le dispositif de déplacement (16) dans une position à l'extérieur du récipient (20), dans laquelle les écarts d'isolation électriques par rapport aux autres composants de l'arrangement de contrôle, nécessaires pour un contrôle électrique de la tension alternative, sont garantis.

2. Arrangement de contrôle selon la revendication 1, **caractérisé en ce que** la bobine à haute tension (12, 60, 110, 140, 172, 192) présente au moins deux segments de bobine (66, 68, 70, 146, 148, 150) branchés électriquement en série et comprenant chacun deux extrémités d'enroulement (72, 74, 76, 78, 80, 82).

3. Arrangement de contrôle selon la revendication 2, **caractérisé en ce que** les au moins deux segments de bobine (66, 68, 70, 146, 148, 150) sont de forme cylindrique creuse et sont disposés de manière adjacente le long de l'axe imaginaire (62, 112, 142, 180, 198), celui-ci traversant les espaces intérieurs cylindriques creux respectifs.

4. Arrangement de contrôle selon la revendication 3, **caractérisé en ce que** les au moins deux segments de bobine (66, 68, 70, 146, 148, 150) le long de l'axe imaginaire (62, 112, 142, 180, 198) sont disposés sur un corps creux cylindrique (64, 144) commun.

5. Arrangement de contrôle selon l'une des revendications 2 à 4, **caractérisé en ce qu'**au moins un condensateur (84, 86, 88, 120, 122, 124, 156, 158) relié mécaniquement avec la bobine à haute tension (12, 60, 110, 140, 172, 192) est associé à chaque segment de bobine (66, 68, 70, 146, 148, 150) et est branché électriquement en parallèle avec les deux extrémités d'enroulement (72, 74, 76, 78, 80, 82) respectives.

6. Arrangement de contrôle selon l'une des revendications 2 à 4, **caractérisé en ce qu'**un circuit électrique série constitué d'au moins deux segments de bobine (146, 148, 150) et un circuit électrique série constitué d'au moins deux condensateurs (156, 158) reliés mécaniquement avec la bobine à haute tension sont branchés électriquement en parallèle l'un avec l'autre.

7. Arrangement de contrôle selon la revendication 6, **caractérisé en ce qu'**au moins un condensateur (156, 158) relié mécaniquement avec la bobine à haute tension est disposé entre deux segments de bobine (146, 148, 150) adjacents le long de l'axe imaginaire (142).

8. Arrangement de contrôle selon l'une des revendications 5 à 7, **caractérisé en ce qu'**au moins un condensateur (84, 86, 88, 120, 122, 124, 156, 158) branché électriquement en parallèle avec les deux extrémités d'enroulement (72, 74, 76, 78, 80, 82) d'un segment de bobine est relié mécaniquement avec celle-ci.

9. Arrangement de contrôle selon l'une des revendications 3 à 8, **caractérisé en ce qu'**au moins un condensateur (120, 122, 124) est disposé dans l'espace intérieur creux des segments de bobine de la bobine à haute tension (110) et relié électriquement avec celle-ci.

10. Arrangement de contrôle selon l'une des revendications précédentes, **caractérisé en ce qu'**à l'extrémité axiale distante de la terre de la bobine à haute tension (172, 192) est prévue une électrode (176, 196) de type toroïdal pour commander le potentiel électrique.

11. Arrangement de contrôle selon la revendication 10, **caractérisé en ce qu'**un diviseur de tension (194) de type colonne est disposé en parallèle avec l'extension de la bobine à haute tension (192) à la même hauteur, le diviseur de tension (194) ainsi que la bobine à haute tension (192) étant reliés électriquement avec l'électrode (196) de type toroïdal.

12. Arrangement de contrôle selon la revendication 11, **caractérisé en ce que** le diviseur de tension (194) de type colonne est disposé à une distance donnée à côté de la bobine à haute tension (192) et relié mécaniquement avec celle-ci.
